# EUROPÄISCHE PATENTSCHRIFT

(11) **EP 2 815 637 B1**
(45) Veröffentlichungstag und Bekanntmachung des Hinweises auf die Patenterteilung: **25.04.2018**
(21) Anmeldenummer: 13701414.8
(22) Anmeldetag: 18.01.2013
(51) Int. Cl.: H05K 5/06, H05K 5/02

(54) **DRUCKAUSGLEICHSELEMENT MIT EINER MEMBRAN, GEHÄUSE, BATTERIEZELLENMODUL SOWIE KRAFTFAHRZEUG**
PRESSURE COMPENSATION ELEMENT HAVING A DIAPHRAGM, HOUSING, BATTERY CELL MODULE AND MOTOR VEHICLE
ÉLÉMENT DE COMPENSATION DE PRESSION COMPRENANT UNE MEMBRANE, UN BOÎTIER ET UN MODULE D'ÉLÉMENTS DE BATTERIE, ET VÉHICULE AUTOMOBILE

(30) Priorität: 13.02.2012 DE 102012202103
(43) Veröffentlichungstag der Anmeldung: 24.12.2014
(73) Patentinhaber: Robert Bosch GmbH, 70442 Stuttgart (DE); Samsung SDI Co., Ltd., Yongin-si Gyeonggi-do 446-577 (KR)
(72) Erfinder: PFLUEGER, Claus, Gerald, 71706 Markgröningen (DE); GLESS, Michael, 70437 Stuttgart-Zazenhausen (DE)
(74) Vertreter: Bee, Joachim
(86) Internationale Anmeldenummer: PCT/EP2013/050925
(87) Internationale Veröffentlichungsnummer: WO 2013/120654

(56) Entgegenhaltungen:
- AU-A4- 2010 100 984
- DE-U1- 20 315 524
- GB-A- 2 401 330

## Beschreibung

Die vorliegende Erfindung betrifft ein Druckausgleichselement für ein Gehäuse, das eine Membran aufweist, ein Gehäuse, ein Batteriezellenmodul sowie ein Kraftfahrzeug.

### Stand der Technik

Es besteht ein erheblicher Bedarf an Batterien für breite Anwendungsbereiche, beispielsweise für Fahrzeuge, stationäre Anlagen, wie zum Beispiel Windkraftanlagen, und mobile Elektronikgeräte, wie zum Beispiel Laptops und Kommunikationsgeräte. An diese Batterien werden sehr hohe Anforderungen hinsichtlich Zuverlässigkeit, Lebensdauer und Leistungsfähigkeit gestellt.

Eine Batteriezelle besteht im Inneren aus elektrochemischen Elementen, die empfindlich auf äußere Einflüsse wie Luft oder Feuchtigkeit reagieren und daher so gut wie möglich davor geschützt werden müssen.

So ist beispielsweise bei Lithium-Ionen-Zellen zur Interkalation sowie zur Deinterkalation die Anwesenheit eines sogenannten Lithium-Ionen-Leitsalzes notwendig. Sowohl für Batteriezellen geringerer Ladung, wie sie zum Beispiel in tragbaren elektronischen Geräten Anwendung finden, als auch in Batteriezellen für den automotiven Bereich wird als Lithium-Leitsalz Lithium-hexa-Fluorophosphat (LiPF₆) eingesetzt. Dieses Leitsalz ist gegenüber Feuchtigkeit äußerst reaktiv, so dass durch Hydrolyse Fluorwasserstoff (HF) entstehen kann.

Insbesondere bei automotiven Anwendungen der Lithium-Ionen-Speichertechnologie muss jedoch zwischen dem Innenraum des Gehäuses der Batterie und der Umgebung ein Druckausgleich stattfinden, da ansonsten durch hohe Umgebungsdruckunterschiede das Gehäuse komprimiert werden oder im anderen Fall sich stark ausdehnen kann. Hohe Druckunterschiede sind bei Flugzeugtransport, bei Gebirgsfahrten, infolge täglicher Druckschwankungen und hohen Temperaturschwankungen gegeben. Das hat im Extremfall zur Folge, dass das Gehäuse der Batterie durch die sehr starke mechanische Belastung zerstört wird.

Daher wird ein permanent ablaufender Volumenaustausch zwischen Gehäuseinnenraum und Umgebung mittels eines Druckausgleichselementes sichergestellt. Das Druckausgleichselement kann durch eine Membran ausgebildet sein. Da in der Umgebungsluft stets ein gewisser Anteil an Wasserdampf enthalten ist, gelangt dieser durch Volumenaustausch und Diffusion durch die Membran in das Gehäuse.

Um genannte Probleme durch Kondenswasser im Inneren des Gehäuses zu verhindern, wird üblicherweise ein Trockenmittel eingesetzt. Auch bei kleinsten Gehäusevolumen ist jedoch über eine Lebensdauer von mehreren Jahren eine Trockenmittelmasse von einigen Kilogramm erforderlich oder es ist ein Austausch des Trockenmittels vorzusehen.

Beispielsweise ist aus der DE 10 2006 053 114 A1 ein Druckausgleichselement für ein Gehäuse zur Aufnahme einer elektronischen Schaltung bekannt, das aus einer semipermeablen Membran besteht, die geschützt in einem elektrischen Steckverbindungselement angeordnet ist. Ein weiteres Beispiel von Druckausgleichselement für ein Gehäuse ist aus der GB-A-2401330 bekannt.

### Offenbarung der Erfindung

Erfindungsgemäß wird ein Druckausgleichselement für ein Gehäuse, beispielsweise zur Aufnahme von Lithium-Ionen-Akkumulatoren, bereitgestellt, bei dem eine Membran, vorzugsweise eine hydrophobe und/oder oleophobe Membran in Reihe mit zumindest zwei parallel und entgegengesetzt zueinander angeordneten Rückschlagventilen geschaltet ist.

Die Rückschlagventile haben jeweils einen definierten Öffnungsdruck, so dass vorteilhafterweise der Volumenaustausch des Gehäuseinnenraums mit der Umgebung und damit ein Eintrag von Feuchtigkeit und sonstigen Verunreinigungen auf ein Minimum reduziert werden kann.

Geeignete Rückschlagventile sind dem Fachmann aus dem Stand der Technik bekannt. Vorzugsweise werden Drosselrückschlag-, Schirm-, Schnabel- oder federbelastete Kugelsitzventile verwendet. Je nach erforderlicher Charakteristik können die genannten Ventile beliebig kombiniert werden.

Zudem können die Ventile je nach Druckbeanspruchung und Öffnungsdruck hinsichtlich des Werkstoffs und/oder der Federn der Ventile variiert werden.

Es können auch mehrere, beliebige Ventile in Reihe und/oder parallel geschaltet werden, um einen kontrollierten Druckausgleich in beide Richtungen zu gewährleisten.

Die Membran ist lediglich gasdurchlässig, so dass feste Verunreinigungen und Flüssigkeiten zurückgehalten werden. Nach einer bevorzugten Ausführungsform kann die Membran hydrophob und/oder oleophob ausgerüstet sein, so dass gegenüber Flüssigkeiten, insbesondere Wasser, ein erhöhter Schutz gegeben ist.

Geeignete Materialien für derartige Membranen sind dem Fachmann aus dem Stand der Technik bekannt, bevorzugt werden Membranen aus Polytetrafluorethylen (PTFE).

Nach einer besonders bevorzugten Ausführungsform des Druckausgleichselements ist dieses mit einem Trockenmittel versehen, das vorzugsweise in einem Trockenmittelbehälter angeordnet ist und dem zumindest zwei Rückschlagventile nachgeordnet sind. Dadurch wird beim Druckausgleich die Luft durch das im Gehäuse befindliche Trockenmittel geführt und eventuell die doch durch die Membran gelangte Feuchtigkeit sicher gebunden.

Vorteilhafterweise kann hierüber sicher gewährleistet werden, dass jegliche Feuchtigkeit am Eindringen in das Gehäuse gehindert wird, wodurch Korrosion und Kurzschlüsse sicher unterbunden werden können.

Die Menge an Trockenmittel kann derart bemessen sein, dass diese über die Lebensdauer beispielsweise eines Akkumulators, der im Gehäuse angeordnet ist, ausreicht.

Alternativ kann die Trockenmittelmenge in einem austauschbaren Trockenmittelbehälter befindlich sein, der in definierten Intervallen auszutauschen ist. Dabei ist besonders vorteilhaft, dass die benötigte Trockenmittelmenge noch geringer gehalten werden kann als bei den anderen Ausführungsformen der Erfindung.

Geeignete Trockenmittel sind dem Fachmann aus dem Stand der Technik allgemein bekannt. Bevorzugt werden Silika, Molekularsieb oder tonbasierte Trockenmittel.

Die Membran wird vorzugsweise mit einer Schutzkappe versehen, so dass mechanische Beschädigungen der Membran verhindert werden können. Auch ein Schutz vor Spritzwasser, beispielsweise bei der Anwendung eines Dampfstrahlreinigers oder bei Steinschlag, ist damit gegeben.

Zudem wird erfindungsgemäß ein Gehäuse, das über ein erfindungsgemäßes Druckausgleichselement verfügt, für feuchtigkeitsempfindliche Bauteile oder Vorrichtungen, bei denen es nicht zu Kondensatbildung kommen darf, wie Steuergeräten oder Batteriemodulen, beansprucht.

Dementsprechend ist Gegenstand dieser Erfindung auch ein Batteriezellenmodul, vorzugsweise ein Lithium-Ionen-Akkumulator mit einem erfindungsgemäßen Gehäuse.

Zudem ist Gegenstand der Erfindung ein Kraftfahrzeug, insbesondere ein elektromotorisch angetriebenes Kraftfahrzeug, welches wenigstens ein erfindungsgemäßes Batteriezellenmodul aufweist, das mit einem Antriebssystem des Kraftfahrzeugs verbunden ist.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 in einer geschnittenen Ansicht ein erfindungsgemäßes Druckausgleichselement,
Figur 2 in einer geschnittenen Ansicht ein erfindungsgemäßes Druckausgleichselement nach einer zweiten Ausführungsform, und
Figur 3 in einer geschnittenen Ansicht ein erfindungsgemäßes Druckausgleichselement nach einer dritten Ausführungsform.

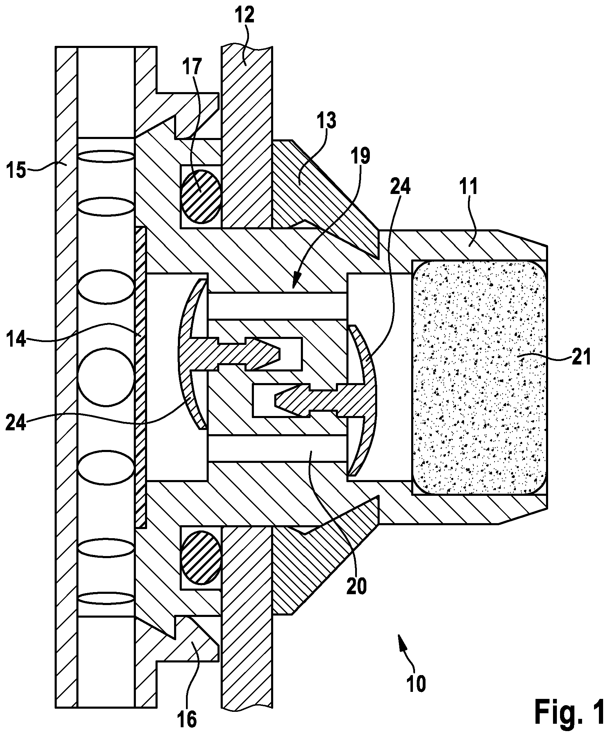

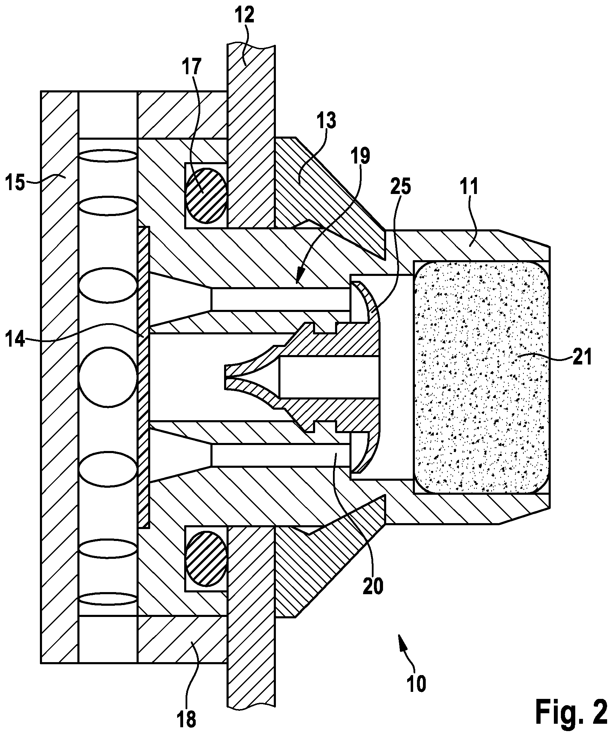

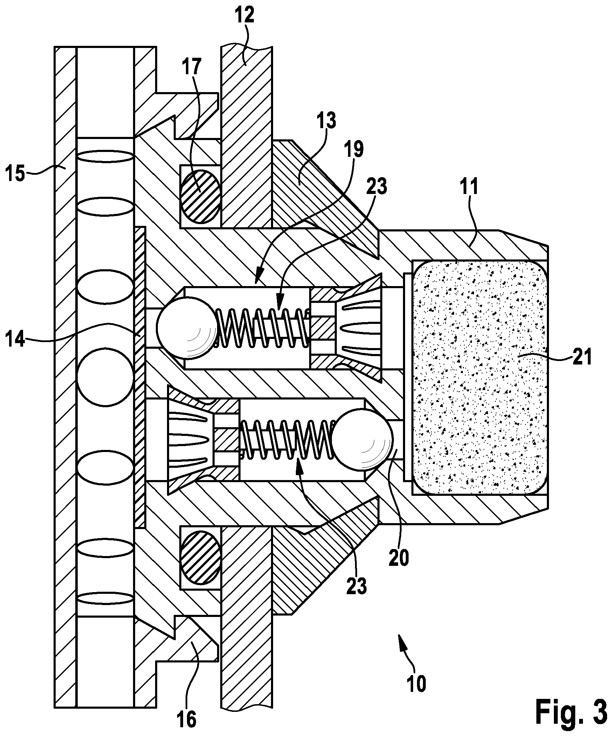

Figur 1, Figur 2 und Figur 3 zeigen jeweils ein erfindungsgemäßes Druckausgleichselement 10, das über einen Grundhalter 11 in einer Durchgangsöffnung einer Wandung 12 eines nicht näher dargestellten Gehäuses angeordnet ist. Der Grundhalter 11 ist auf der Innenseite des Gehäuses mittels eines Schnappverschlusses 13 oder einer nicht dargestellten Schraubverbindung fixiert. Auch andere Befestigungsarten sind möglich. Auf der Außenseite des Gehäuses trägt der Grundhalter 11 eine Membran 14, die von einer Schutzkappe 15 überdeckt ist. Radial sind an der Schutzkappe 15 Bohrungen vorgesehen, durch die Luft und Wasser gelangen kann. Die Luft kann durch die Membran 14 weiter in das Gehäuse oder aus dem Gehäuse gelangen. Das Wasser wird durch die Bohrungen wieder an die Umgebung abgegeben. Die Bohrungen können auch die Form von Schlitzen besitzen. Die Schutzkappe 15 kann über einen Schnappverschluss 16, wie in Figur 1 und 3 dargestellt, gehalten werden oder, wie in Figur 2 gezeigt, über eine Pressverbindung 18. Die Verbindung kann aber auch in anderer Weise gegeben sein, beispielsweise durch Aufschrauben, Aufschweißen oder durch direkte Anformung. Der Grundhalter 11 ist gegenüber der Wandung 12 mittels einer Nebenabdichtung 17 abgedichtet. Im Inneren des Grundhalters 11 sind Rückschlagventile 19 im Bereich von Ein- bzw. Ausströmbereichen von Durchgangsöffnungen 20 angeordnet, um den Druckausgleich zu kontrollieren. Als Rückschlagventile 19 sind zwei Schirmventile 24 (Figur 1), eine Kombination aus Schirm- und Schnabelventil 25 (Figur 2) sowie federbelastete Kugelsitzventile 23 (Figur 3) vorgesehen. Der Grundhalter 11 weist auf der Innenseite des Gehäuses einen mit Trockenmittel gefüllten Behälter 21 auf, durch den die ausgetauschte Luft in den Innenraum des Gehäuses gelangt und dabei getrocknet wird. Der Behälter 21 kann mit dem Grundhalter 11 verclipst, verpresst oder verschraubt sein.

## Patentansprüche

1. Ein Druckausgleichselement für ein Gehäuse, das eine Membran (14) aufweist, **dadurch gekennzeichnet, dass** die Membran (14) in Reihe mit zumindest zwei parallel und entgegengesetzt zueinander angeordneten Rückschlagventilen (19) geschaltet ist.

2. Das Druckausgleichselement nach Anspruch 1, wobei die Membran (14) eine hydrophobe und/oder oleophobe Membran (14) ist.

3. Das Druckausgleichselement nach Anspruch 1 oder 2, wobei das Druckausgleichselement (10) ein Trockenmittel aufweist, das der Membran (14) und den zumindest zwei Rückschlagventilen (19) nachgeordnet ist.

4. Das Druckausgleichselement nach einem der Ansprüche 1 bis 3, wobei die Membran (14) mit einer Schutzkappe (15) überdeckt ist.

5. Das Druckausgleichselement nach einem der Ansprüche 1 bis 4, wobei die Membran (14) aus Polytetrafluorethylen besteht.

6. Das Druckausgleichselement nach einem der Ansprüche 1 bis 5, wobei die Rückschlagventile (19) aus folgender Gruppe ausgewählt sind:
Drosselrückschlag-, Schirm-, Schnabel-, federbelastete Kugelsitzventile und Kombinationen genannter Ventile.

7. Ein Gehäuse ein Druckausgleichselement (10) nach einem der Ansprüche 1 bis 6 aufweisend.

8. Ein Batteriezellenmodul ein Gehäuse nach Anspruch 7 aufweisend.

9. Das Batteriezellenmodul nach Anspruch 8, wobei das Batteriezellenmodul ein Lithium-Ionen-Akkumulator ist.

10. Ein Kraftfahrzeug, insbesondere elektromotorisch antreibbares Kraftfahrzeug, mit einem Batteriezellenmodul nach Anspruch 8 oder 9, wobei das Batteriezellenmodul mit einem Antriebssystem des Kraftfahrzeuges verbunden ist.

## Claims

1. A pressure equalization element for a housing, which has a membrane (14), **characterized in that** the membrane (14) is connected in series with at least two non-return valves (19) arranged parallel and in opposition to each other.

2. The pressure equalization element according to Claim 1, wherein the membrane (14) is a hydrophobic and/or oleophobic membrane (14).

3. The pressure equalization element according to Claim 1 or 2, wherein the pressure equalization element (10) has a drying means, which is connected to the output side of the membrane (14) and the at least two non-return valves (19).

4. The pressure equalization element according to one of Claims 1 to 3, wherein the membrane (14) is covered by a protective cap (15).

5. The pressure equalization element according to one of Claims 1 to 4, wherein the membrane (14) is composed of polytetrafluoroethylene.

6. The pressure equalization element according to one of Claims 1 to 5, wherein the non-return valves (19) are selected from the following group:
throttling non-return valves, screen valves, spout valves, spring-loaded ball seat valves and combinations of the stated valves.

7. A housing having a pressure equalization element (10) according to one of Claims 1 to 6.

8. A battery cell module having a housing according to Claim 7.

9. The battery cell module according to Claim 8, wherein the battery cell module is a lithium-ion accumulator.

10. A motor vehicle, in particular a motor vehicle capable of being driven by an electric motor, having a battery cell module according to Claim 8 or 9, wherein the battery cell module is connected to a drive system of the motor vehicle.

## Revendications

1. Élément de compensation de pression pour un boîtier, qui présente une membrane (14), **caractérisé en ce que** la membrane (14) est montée en série avec au moins deux clapets antiretour (19) disposés parallèlement et de manière opposée l'un à l'autre.

2. Élément de compensation de pression selon la revendication 1, dans lequel la membrane (14) est une membrane hydrophobe et/ou oléophobe (14).

3. Élément de compensation de pression selon la revendication 1 ou 2, dans lequel l'élément de compensation de pression (10) présente un moyen de séchage qui est placé après la membrane (14) et les au moins deux clapets antiretour (19).

4. Élément de compensation de pression selon l'une quelconque des revendications 1 à 3, dans lequel la membrane (14) est recouverte d'un capuchon de protection (15).

5. Élément de compensation de pression selon l'une quelconque des revendications 1 à 4, dans lequel la membrane (14) se compose de polytétrafluoroéthylène.

6. Élément de compensation de pression selon l'une quelconque des revendications 1 à 5, dans lequel les clapets antiretour (19) sont choisis parmi le groupe suivant :
clapets antiretour à étranglement, clapets parapluie, clapets à bec, clapets sphériques chargés par ressort et des combinaisons desdits clapets.

7. Boîtier présentant un élément de compensation de pression (10) selon l'une quelconque des revendications 1 à 6.

8. Module de cellule de batterie présentant un boîtier selon la revendication 7.

9. Module de cellule de batterie selon la revendication 8, dans lequel le module de cellule de batterie est un accumulateur lithium-ions.

10. Véhicule automobile, en particulier véhicule automobile pouvant être entraîné par un moteur électrique, comprenant un module de cellule de batterie selon la revendication 8 ou 9, dans lequel le module de cellule de batterie est connecté à un système d'entraînement du véhicule automobile.
